(19)

Europäisches Patentamt
European Patent Office
Office européen des brevets

(11) **EP 4 250 882 A1**

(12) **EUROPEAN PATENT APPLICATION**
published in accordance with Art. 153(4) EPC

(43) Date of publication:
**27.09.2023 Bulletin 2023/39**

(21) Application number: **21902181.3**

(22) Date of filing: **30.09.2021**

(51) International Patent Classification (IPC):
**H05K 5/02** (2006.01)     **C03C 15/00** (2006.01)
**H04M 1/02** (2006.01)

(52) Cooperative Patent Classification (CPC):
**C03C 15/00; H04M 1/02**

(86) International application number:
**PCT/CN2021/122256**

(87) International publication number:
**WO 2022/121473 (16.06.2022 Gazette 2022/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.12.2020 CN 202011435572**

(71) Applicant: **GUANGDONG OPPO MOBILE TELECOMMUNICATIONS CORP., LTD.**
**Dongguan, Guangdong 523860 (CN)**

(72) Inventor: **ZOU, Pan**
**Dongguan, Guangdong 523860 (CN)**

(74) Representative: **Ipside**
**7-9 Allées Haussmann**
**33300 Bordeaux Cedex (FR)**

(54) **HOUSING ASSEMBLY, PREPARATION METHOD THEREFOR AND ELECTRONIC DEVICE**

(57)     A housing assembly is provided in the present disclosure. The housing assembly includes a glass body. The glass body has a first surface. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6\text{-}3^{1/2}/2)$. The housing assembly can realize an anti-fingerprint effect and an anti-glare effect. In the meanwhile, the pointed protrusion has multiple lateral surfaces, such that a light can be reflected to produce a pearlescent effect, and an appearance of the housing assembly is greatly improved. In addition, most of pointed protrusions each have similar length and width, such that pearlescent effects of the pointed protrusion at different angles are the same, and a consistency of the pearlescent effects is improved. A method for preparing a housing assembly and an electronic device are further provided.

FIG. 1

EP 4 250 882 A1

**Description**

TECHNICAL FIELD

This disclosure relates to the field of electronic product technology, and in particular to a housing assembly and a method for preparing the same, and an electronic device.

BACKGROUND

With continuous developments of electronic devices, users have higher and higher requirements for appearance of the electronic devices. Therefore, in order to meet increasingly high aesthetic requirements of a user, an appearance of the electronic device also needs to be continuously developed and enriched to provide the user with a better use experience.

SUMMARY

In view of this, a housing assembly, a method for preparing a housing assembly, and an electronic device are provided in the present disclosure. The housing assembly has an anti-glare effect and a pearlescent effect, and can present a sparkling visual effect, such that the housing assembly and the electronic device can be more expressive in appearance, and competitiveness of a product is enhanced.

In a first aspect, a housing assembly is provided in the present disclosure. The housing assembly includes a glass body. The glass body has a first surface. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

In a second aspect, a method for preparing a housing assembly is provided in the present disclosure. The method includes the following. A frosting liquid is provided. Frosting treatment is performed on a first surface of a glass-body precursor and the glass-body precursor frosted is washed to obtain the housing assembly. The frosting liquid contains fluorosilicic acid. In the frosting liquid, cations reacting with the fluorosilicic acid are ammonium ions. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

In a third aspect, an electronic device is provided in the present disclosure. The electronic device includes a housing assembly and a main board. The housing assembly includes a glass body. The glass body has a first surface. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

BRIEF DESCRIPTION OF THE DRAWINGS

In order to explain technical solutions in implementations of the present disclosure more clearly, the following will describe accompanying drawings used for the implementations of the present disclosure.

FIG. 1 is a schematic structural view of a housing assembly provided in an implementation of the present disclosure.
FIG. 2 is an enlarged view of region A in FIG. 1.
FIG. 3 is a top view of a first surface of a glass body provided in an implementation of the present disclosure.
FIG. 4 is a schematic structural view of a housing assembly provided in an implementation of the present disclosure.
FIG. 5 is a schematic structural view of a housing assembly provided in another implementation of the present disclosure.
FIG. 6 is a schematic structural view of an electronic device provided in an implementation of the present disclosure.
FIG. 7 is an appearance effect view of a housing assembly prepared in implementation 1.
FIG. 8 is a schematic view of surface microstructures of a housing assembly prepared in implementation 1.
FIG. 9 a schematic view of surface microstructures of a housing assembly prepared in comparative example 1.

Reference signs:

glass body-10, first surface-101, second surface-102, pointed protrusion-11, apex-111, base-112, lateral surface-113, decorative layer-20, housing assembly-100.

DETAILED DESCRIPTION

The following are preferred implementations of the present disclosure. It should be noted that for those of ordinary skill in the art, without departing from a concept of the present disclosure, several modifications and improvements can be made, and these modifications and improvements are also regarded to fall in the protection scope of the present disclosure.

Many different implementations or examples are provided in the following disclosure to implement different structures of the present disclosure. In order to simplify the present disclosure, certain components and arrangements of specific examples are described below. These components and arrangements are only examples and are not intended to limit the present disclosure. In addition, reference numerals/reference characters may be repeated in different examples in the present disclosure. This repeating is for the purpose of simplification and clarity and does not indicate relationships between different implementations and/or arrangements. Moreover, examples of various processes and materials are provided in the present disclosure. However, it would be appreciated by those skilled in the art that other processes and/or materials may also be applied.

A housing assembly is provided in implementations of the present disclosure. The housing assembly includes a glass body. The glass body has a first surface. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

In implementations, the housing assembly of claim 1, wherein the multiple pointed protrusions have at least one of a triangular pyramid structure or a triangular pyramid-like structure.

In implementations, in the multiple pointed protrusions, at least 95% of the multiple pointed protrusions each have the length-width ratio of $1:(0.7-3^{1/2}/2)$.

In implementations, each of the multiple pointed protrusions has a height ranging from $0.5\mu m$ to $3\mu m$.

In implementations, each of the multiple pointed protrusions has a length ranging from $20\mu m$ to $200\mu m$.

In implementations, an interval between adjacent pointed protrusions ranges from $0\mu m$ to $30\mu m$.

In implementations, each of the multiple pointed protrusions has a length-height ratio greater than 7.

In implementations, the three lateral surfaces have an area ratio of $1:(0.9-1):(0.9:1)$.

In implementations, each of the multiple pointed protrusions has a first edge, a second edge, and a third edge, and a ratio of the first edge to the second edge to the third edge is $1:(0.8-1):(0.8:1)$.

In implementations, the multiple pointed protrusions each have a first edge, a second edge, and a third edge, and a ratio of the first edge to a height of the pointed protrusion is $1:(0.01-15)$.

In implementations, the first surface has a surface roughness ranging from $0.5\mu m$ to $3\mu m$, and the glass body has a haze ranging from 30% to 90% and a transmittance ranging from 10% to 80%.

In implementations, the glass body is tempered glass.

In implementations, the housing assembly further includes a protective layer disposed on the first surface of the glass housing. The protective layer has a thickness less than $50\mu m$.

A method for preparing a housing assembly is provided in implementations of the present disclosure. The method includes the following. A frosting liquid is provided. Frosting treatment is performed on a first surface of a glass-body precursor and the glass-body precursor frosted is washed to obtain the housing assembly. The frosting liquid contains fluorosilicic acid. In the frosting liquid, cations reacting with the fluorosilicic acid are ammonium ions. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

In implementations, based on parts by weight, the frosting liquid includes 60-100 parts of fluoroammonium salt, 2.5-10 parts of fluorosilicic acid, 35-50 parts of inorganic acid, and 30-50 parts of water.

In implementations, based on parts by weight, the frosting liquid includes 30-50 parts of ammonium hydrogen fluoride ($NH_4HF_2$), 30-50 parts of ammonium fluoride ($NH_4F$), 2.5-10 parts of fluorosilicic acid, 35-50 parts of inorganic acid, and 30-50 parts of water.

In implementations, the frosting treatment is performed at 5°C-40°C for 1min-10min.

In implementations, before preforming the frosting treatment, the frosting liquid is cured for 24h-36h.

In implementations, the method further includes the following. The housing assembly is reinforced.

An electronic device is provided in implementations of the present disclosure. The electronic device includes a housing assembly and a main board. The housing assembly includes a glass body. The glass body has a first surface. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of $1:(0.6-3^{1/2}/2)$.

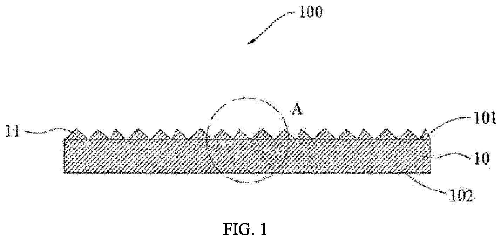

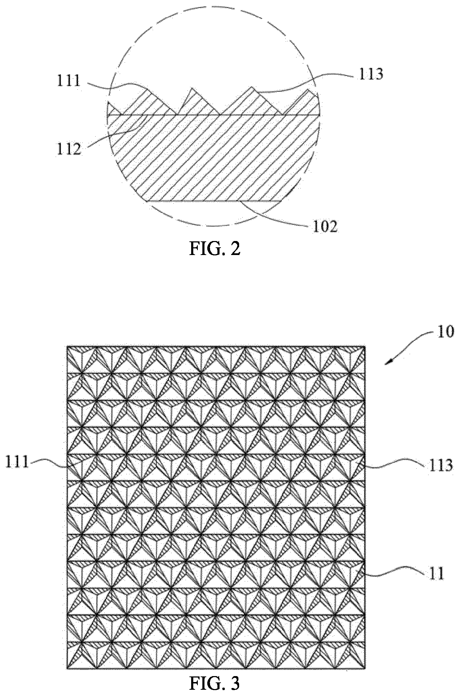

Reference is made to FIG. 1, which is a schematic structural view of a housing assembly provided in an implementation of the present disclosure. A housing assembly 100 includes a glass body 10. The glass body 10 has a first surface 101. The first surface 101 has multiple micrometer-sized pointed protrusions 11. Reference is made to FIG. 2, which is an enlarged view of region A in FIG. 1. Each of the multiple pointed protrusions 11 includes an apex 111, a base 112, and three lateral surfaces 113 each extending from the apex 111 to the base 112. In the multiple pointed protrusions 11, at least 95% of the multiple pointed protrusions 11 each have a length-width ratio of 1:(0.6-$3^{1/2}$/2).

In the present disclosure, the first surface 101 of the glass body 10 has the multiple micrometer-sized pointed protrusions 11, such that the housing assembly 100 has a frosting effect, and a contact area between the pointed protrusions 11 and a finger is small, thereby realizing an anti-fingerprint effect, an anti-scratch effect, and an anti-glare effect. Further, the pointed protrusion 11 has multiple lateral surfaces 113, and lights are reflected on the multiple lateral surfaces 113. Due to different angles of the lateral surfaces 113, reflected lights in different directions can be generated, such that a sparkling pearlescent effect can be realized, and a visual effect of the housing assembly 100 can be greatly enriched. In the meanwhile, most of the pointed protrusions 11 each have similar length and width, and have a good uniformity in morphology and size, such that the multiple lateral surfaces 113 have similar areas, and the reflected lights on different lateral surfaces 113 have similar intensities, thereby ensuring a consistency of a sparkling intensity of the pointed protrusion 11 at different angles and improving a consistency and a uniformity of the pearlescent effect. In the related art, a housing assembly 100 only has a frosting effect, most of a surface of the housing assembly 100 has round granular protrusions, and the round granular protrusions each have a small particle size, are easy to cause diffuse reflection, and the housing assembly 100 has no pearlescent effect. The housing assembly 100 needs to be used with a pearlescent ink to have the pearlescent effect. In the housing assembly 100 provided in the present disclosure, there is no need to use the pearlescent ink, such that a production process is simplified and costs are saved. In the meanwhile, the pointed protrusions 11 of the first surface 101 have good uniformity in morphology and each have similar length and width, such that the pearlescent effect can be uniform and consistent at different angles, and a uniformity and a consistency of an appearance effect of housing assembly 100.

It can be understood that the first surface 101 of the glass body 10 is a first surface 101 of the housing assembly 100. At least one surface of the glass body 10 has the pointed protrusions 11. Reference is made to FIG. 1, the glass body 10 has the first surface 101 and a second surface 102 disposed opposite to the first surface 101. The second surface 102 may or may not have pointed protrusions 11, which is not limited. It can be understood that "first" and "second" in the present disclosure are only used for descriptive purposes.

In the present disclosure, the first surface 101 of the glass body 10 has the multiple micrometer-sized pointed protrusions 11. The pointed protrusion 11 includes the apex 111, the base 112, and the three lateral surfaces 113 each extending from the apex 111 to the base 112. Lights are reflected on the multiple lateral surfaces 113, such that the pointed protrusion 11 becomes a sparkling point, and the multiple pointed protrusions 11 make the housing assembly 100 present a sparkling visual effect.

In implementations of the present disclosure, the pointed protrusion 11 includes the apex 111, the base 112, and the three lateral surfaces 113 each extending from the apex 111 to the base 112. On condition that the pointed protrusions 11 have the same size, compared with a pointed protrusion having four or more than four lateral surfaces 113, the three lateral surfaces 113 each have a relatively large area, such that more lights can be reflected and a stronger sparkling effect can be produced. In the meanwhile, the pointed protrusions 11 are uniform in morphology, and each pointed protrusion 11 has a similar pearlescent effect, such that the uniformity of the pearlescent effect of the housing assembly 100 is improved. Here, the three lateral surfaces 113 intersect in pairs to form three edges.

In an implementation of the present disclosure, the multiple pointed protrusions 11 may have at least one of a triangular pyramid structure or a triangular pyramid-like structure. Here, the pointed protrusion 11 has the triangular pyramid (or pyramid-like) structure, such that the lateral surfaces 113 are more consistent in area distribution, are uniform in morphology and structure, and have a highly consistent sparkling effect at different angles. Therefore, the first surface 101 has an excellent uniformity in microstructure, a uniformity of the pearlescent effect of the housing assembly 100 in macroscopic view is better improved, and a quality of the housing assembly 100 is improved. In the present disclosure, the triangular pyramid-like structure is similar to the triangular pyramid structure. For example, the apex 111 of the triangular pyramid-like structure is planar. In the present disclosure, it is sufficient that the pointed protrusion 11 may be substantially consistent with the triangular pyramid (pyramid-like) structure in morphology and structure, and a certain deviation is allowed. Here, the three lateral surfaces 113 intersect in pairs to form the three edges. Reference is made to FIG. 3, which is a top view of a first surface of a glass body provided in an implementation of the present disclosure. The pointed protrusion 11 of the first surface 101 of the glass body 10 has the triangular pyramid structure, and when the lights are irradiated on the pointed protrusion 11, there will be strong reflections, such as specular reflections, on the lateral surfaces 113, thereby producing the sparkling effect and improving the visual effect of the housing assembly 100.

In the present disclosure, a length of the pointed protrusion 11 is a maximum value of an interval between any two points on a contour line of an orthographic projection of the pointed protrusion 11 on the second surface 102. In a direction perpendicular to a length direction, a width of the pointed protrusion 11 is a maximum value of an interval between any two points on the contour line of the orthographic projection. A height of the pointed protrusion 11 is an interval between the apex 111 and the base 112. Since the pointed protrusion 11 has a micrometer-sized structure with a relatively small size, and relatively speaking, the pointed protrusion 11 has a length-width ratio of (0.6-3$^{1/2}$/2), that is, $1:(0.6-\sqrt{3}/2)$. The length and the width of the pointed protrusion 11 are similar, and the height of the pointed protrusion 11 is in micrometer-sized, such that the multiple lateral surfaces 113 of the pointed protrusion 11 have similar areas, and the reflected lights on different lateral surfaces 113 have similar intensities, thereby ensuring the consistency of the sparkling intensity of the pointed protrusion 11 at different angles and improving the consistency and the uniformity of the pearlescent effect. In the present disclosure, in the multiple pointed protrusions, at least 95% of the multiple pointed protrusions each have a length-width ratio of 1:(0.6-3$^{1/2}$/2). It can be understood that if the number of all the multiple pointed protrusions 11 of the first surface 101 is 100%, the at least 95% of the multiple pointed protrusions 11 each have the length-width ratio satisfying the above condition. Specifically, by measuring a length and a width of each pointed protrusion within a unit area and calculating length-width ratios, it can be found that a length-width ratio of each of at least 95% of pointed protrusions 11 is in the above range by analysis. It can be seen that the length-width ratio of each of most of pointed protrusions 11 satisfies the condition, such that the pointed protrusions 11 have similar length-width ratios and a good uniformity. Specifically, it may be, but is not limited to, at least 96%, at least 97%, at least 98%, at least 99%, etc., of the multiple pointed protrusions 11 each satisfying the condition. In an implementation, the length-width ratio of the pointed protrusion 11 is 1:(0.6-3$^{1/2}$/2). All pointed protrusions 11 satisfy the above condition, such that the morphology is highly uniform and consistent, and a macroscopic pearlescent effect is more uniform. In another implementation, in the multiple pointed protrusions 11, at least 95% of the multiple pointed protrusions 11 have a length-width ratio of 1:(0.6-3$^{1/2}$/2). When the pointed protrusion 11 has a triangular pyramid structure or a triangular pyramid-like structure, an orthographic projection of the pointed protrusion 11 on the second surface 102 is more similar to an equilateral triangle, and the morphology and structure are more regular, which is beneficial to improving the uniformity of the pearlescent effect. Further, the length-width ratio of the pointed protrusion 11 is 1:3$^{1/2}$/2. When the pointed protrusion 11 has the triangular pyramid structure or the triangular pyramid-like structure, the orthographic projection of the pointed protrusion 11 on the second surface 102 is the equilateral triangle, such that the morphology is uniform and consistent, and the pearlescent effect has an excellent consistency. In another implementation, the length-width ratio of pointed protrusion 11 is 1:(0.6-0.7). Specifically, the length-width ratio of pointed protrusion 11 may be, but is not limited to, 1:0.62, 1:0.63, 1:0.65, 1:0.67, 1:0.68, 1:0.71, 1:0.72, 1:0.75, 1:0.76, 1:0.77, 1:0.78, 1:0.79, 1:0.8, 1:0.81, 1:0.82, 1:0.84, 1:0.85, 1:0.86, etc. In an implementation, the length of the pointed protrusion 11 is 20μm-200μm. Furthermore, the length of the pointed protrusion 11 is 20μm-100μm. Specifically, the length of the pointed protrusion 11 may be, but is not limited to, 20μm, 35μm, 50μm, 60μm, 80μm, 95μm, 100μm, 110μm, 120μm, 135μm, 150μm, 165μm, 170μm, 180μm, 190μm, 200μm, etc. In another implementation, the width of the pointed protrusion 11 is 15μm-160μm. Furthermore, the width of the pointed protrusion 11 is 20μm-150μm. Specifically, the width of the pointed protrusion 11 may be, but is not limited to, 20μm, 25μm, 30μm, 50μm, 65μm, 80μm, 90μm, 100μm, 110μm, 125μm, 130μm, 145μm, 150μm, etc. In yet another implementation, the pointed protrusion 11 has the length of 20μm-200μm and the width of 15μm-160μm. The pointed protrusions 11 in the above range are relatively similar in morphology and size, thereby ensuring a uniformity and a consistency of a macroscopic appearance effect of the first surface 101.

In implementations of the present disclosure, the at least 95% of the multiple pointed protrusions 11 each have the length-width ratio of 1:(0.6-3$^{1/2}$/2), and these pointed protrusions 11 are uniformly distributed on the first surface 101, such that the uniformity of the pearlescent effect can be improved.

In implementations of the present disclosure, each of the multiple pointed protrusions 11 has a length-height ratio greater than 7. Therefore, in the micrometer-sized pointed protrusion 11, a change of the height will not affect the morphology of the pointed protrusion 11 too much, thereby ensuring the uniformity of the morphology of the pointed protrusions 11 and the uniformity of the pearlescent effect. In an implementation, the length-width ratio of each of the multiple pointed protrusions 11 is 1:(0.6-3$^{1/2}$/2), and the length-height ratio of each of the multiple pointed protrusions 11 is greater than 7. Further, a length-height ratio of each of the multiple pointed protrusions 11 is greater than 10. Furthermore, the length-height ratio of each of the multiple pointed protrusions 11 is not greater than 400. Therefore, a roughness of the first surface 101 can be ensured, such that the first surface 101 has a good anti-fingerprint effect, a good anti-glare effect, and a good anti-slip effect. In an implementation, the height of each of the multiple pointed protrusions 11 is 0.5μm-3μm. Therefore, the glass body 10 has a frosting sense of touch and an anti-fingerprint effect, no three-dimensional (3D) sense of touch will be excessively improved, and a smooth texture is kept. Further, the height of the each of the multiple pointed protrusions 11 is 1μm-2.5μm. Furthermore, the height of each of the multiple pointed protrusions 11 is 1.2μm-2.2μm. Specifically, the height of each of the multiple pointed protrusions 11 may be, but is not limited to, 0.5μm, 0.6μm, 0.8μm, 1μm, 1.5μm, 2μm, 2.5μm, 3μm, etc.

In the present disclosure, adjacent pointed protrusions 11 may be seamlessly connected with each other, or spaced apart from each other. In implementations of the present disclosure, an interval between the adjacent pointed

protrusions 11 is 0μm-30μm, such that a dense or relatively dispersed pearlescent effect is realized. It can be understood that the interval between the adjacent pointed protrusions 11 is a minimum distance between contours of orthographic projections of the adjacent pointed protrusions 11 on the second surface 102. Specifically, the interval between the adjacent pointed protrusions 11 may be, but is not limited to, 0μm, 0.5μm, 3μm, 5μm, 10μm, 16μm, 20μm, 25μm, 30μm, etc. In an implementation, the pointed protrusions 11 each with the length-width ratio of 1:(0.6-3$^{1/2}$/2) are uniformly dispersed on the first surface 101, and the interval between any adjacent pointed protrusions 11 of the first surface 101 may be the same or different.

In an implementation of the present disclosure, the three lateral surfaces 113 have an area ratio of 1:(0.9-1):(0.9:1), and the three lateral surfaces 113 have similar area, so the pearlescent effect at different angles has a high consistency. Further, the area ratio of the three lateral surfaces 113 is 1:(0.95-1):(0.95: 1). In the present disclosure, each of the three lateral surfaces 113 and the second surface 102 define an acute angle therebetween. In an implementation of the present disclosure, the acute angle is 10°-80°, such that each of the three lateral surfaces 113 can reflect an incident light in a wider angle range, thereby producing a sparkling effect. Further, the acute angle is 30°-60°. Specifically, the acute angle may be, but is not limited to, 10°, 20°, 30°, 40°, 50°, 60°, 70°, 80°, etc. In the present disclosure, adjacent lateral surfaces 113 define an angle therebetween. In an implementation of the present disclosure, the angle between adjacent lateral surfaces 113 is an obtuse angle, such that an intensity of a reflected light can be greatly enhanced and the pearlescent effect can be improved.

In the present disclosure, when the multiple pointed protrusions 11 have at least one of the triangular pyramid structure or the triangular pyramid-like structure, the three lateral surfaces 113 intersect in pairs to form the three edges. It can be understood that the orthographic projection of the pointed protrusion 11 on the second surface 102 is a triangle, the length of the pointed protrusion 11 is a length of a maximum side of the triangle, and the width of the pointed protrusion 11 is an altitude from a vertex of the triangle opposite to the maximum side of the triangle to the maximum side of the triangle. In implementations of the present disclosure, the pointed protrusion 11 has a first edge, a second edge, and a third edge. In an implementation of present disclosure, the first edge, the second edge, and the third edge have a length ratio of 1:(0.8-1):(0.8:1). The three edges have similar lengths, such that the lateral surfaces 113 of the pointed protrusion 11 have similar areas, and the pearlescent effect is highly consistent at different angles. Further, the length ratio of the first edge, the second edge, and the third edge is 1 :(0.9-1):(0.9: 1). Specifically, the length of the first edge may be, but is not limited to, 15μm-55μm. In another implementation in the present disclosure, a ratio of the first edge to the height of the pointed protrusion 11 is 1:(0.01-15). Therefore, the pointed protrusions 11 are relatively uniform in morphology, and the intensity of the pearlescent effect is improved. Further, the ratio of the first edge to the height of the pointed protrusion 11 is 1:(0.5-10).

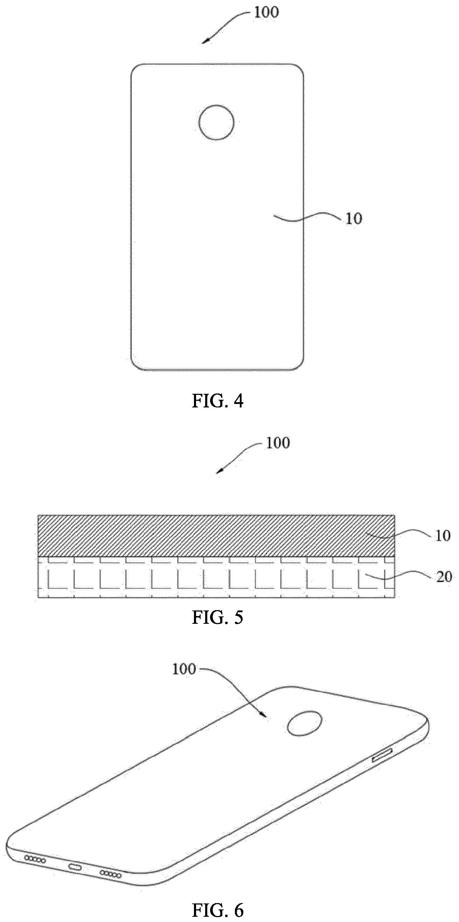

In implementations of the present disclosure, at least part of the housing assembly 100 includes a glass body 10, such that the housing assembly 100 has the frosting effect and the sparkling pearlescent effect, which is rich in visual effect and strongly expressive. In an implementation, part of the housing assembly 100 includes the glass body 10 and other materials, such that different material regions of the housing assembly 100 have different appearance effects, and the housing assembly 100 is more expressive in appearance. In another implementation, the glass body 10 serves as the housing assembly 100, such that the whole housing assembly 100 has the frosting effect and the pearlescent effect, and the consistency is good as the whole. Reference is made to FIG. 4, which is a schematic structural view of a housing assembly provided in an implementation of the present disclosure. The glass body 10 serves as the housing assembly 100. It can be understood that the housing assembly 100 has an inner surface and an outer surface disposed opposite to the inner surface in use. Here, the first surface 101 is the outer surface or part of the outer surface of the housing assembly 100, such that both the frosting effect and the pearlescent effect of the housing assembly 100 can be presented.

Reference is made to FIG. 5, which is a schematic structural view of a housing assembly provided in an implementation of the present disclosure. The housing assembly 100 further includes a decorative layer 20 disposed on the second surface 102 of the glass body 10. Specifically, the decorative layer 20 may be, but is not limited to, at least one of a color layer, an optical film layer, a texture layer, a protective layer, and a covering layer. The color layer is configured to provide colors. The optical film layer is able to produce a visual effect of light and shadow flowing. The texture layer is able to provide a texture effect. The protective layer is configured to protect the housing assembly 100. The covering layer is able to shield the light from one side of the housing assembly 100. In an implementation, the texture layer, the optical film layer, the color layer, and the covering layer are sequentially disposed on the second surface 102 of the glass body 10. In another implementation, the optical film layer, the color layer, and the covering layer are sequentially disposed on the second surface 102 of the glass body 10. In yet another implementation, the protective layer is disposed on the first surface 101 of the glass body 10 to protect the housing assembly 100. Further, the protective layer has a thickness less than 50μm, so as to protect the housing assembly without affecting the pearlescent effect of the pointed protrusion 11 of the first surface 101.

In the present disclosure, the glass body 10 may have a two dimensional (2D) structure, a two-and-a-half dimensional (2.5D) structure, or a 3D structure, and a specific shape and a specific size can be selected according to application needs, thereby determining a shape and a structure of the housing assembly 100. A thickness of the glass body 10 and a thickness of the housing assembly 100 can also be selected according to application needs. Specifically, the thickness of the glass 10 and the thickness of the housing assembly 100 each can be selected from 0.1mm-1mm, 0.2mm-0.8mm, or 0.3mm-0.6mm, etc.

In implementations of the present disclosure, the first surface 101 has a surface roughness of 0.5μm-3μm. If a surface roughness is too small, a frosting effect and a pearlescent effect will be affected, and if the surface roughness is too large, a sense of touch of the housing assembly 100 will be affected. When the surface roughness of the first surface 101 is 0.5μm-3μm, the housing assembly 100 can have an obvious sense of touch and a 3D sense, and have an excellent anti-fingerprint effect, an excellent anti-glare effect, and an excellent anti-slip effect. In the meanwhile, distributions of the pointed protrusions 11 are denser and an interval between adjacent pointed protrusions 11 is smaller, such that the housing assembly 100 in the same range has a stronger pearlescent effect. In an implementation, the surface roughness of the first surface 101 is 0.7μm-1.1μm. Therefore, a surface of the housing assembly 100 has a good frosting effect, and a more delicate and uniform pearlescent effect. In another implementation, the surface roughness of the first surface 101 is 1.5μm-2.5μm. Therefore, the surface of the housing assembly 100 has a good frosting effect and a good pearlescent effect, an obvious 3D sense of touch, and a better anti-fingerprint effect and a better anti-slip effect. Specifically, the surface roughness of the first surface 101 may be, but is not limited to, 0.5μm, 0.6μm, 0.8μm, 0.9μm, 1μm, 1.2μm, 1.3μm, 1.4μm, 1.6μm, 1.7μm, 1.8μm, 1.9μm, 2μm, 2.1μm, 2.2μm, 2.3μm, 2.4μm, 2.6μm, 2.7μm, 2.8μm, or 2.9μm.

In implementations of the present disclosure, the glass body 10 has a haze of 30%-90%. There, the housing assembly 100 has a hazy visual effect and an aesthetic feeling is improved. In an implementation, the haze of the glass body 10 is 30%-50%. The glass body 10 has a low haze, such that the housing assembly 100 has a visual effect that is faintly visible. In another implementation, the haze of the glass body 10 is 70%-90%. The glass body 10 has a relatively high haze, such that the housing assembly 100 has a relatively good shielding effect. Specifically, the haze of the glass body 10 may be, but is not limited to, 30%, 40%, 50%, 55%, 60%, 70%, 75%, 80%, 88%, 90%, etc.

In implementations of the present disclosure, the glass body 10 has a transmittance of 10%-80%. In the present disclosure, the transmittance of the glass body 10 is a transmittance of a light at a wavelength of 420nm-780nm. The glass body 10 has a relatively wide transmittance range, and a transmittance needed can be selected according to actual needs. In an implementation, the transmittance of the glass body 10 is 10%-30%. Here, the transmittance of the glass body 10 is relatively low, such that more lights are reflected, thereby producing a relatively strong pearlescent effect. In another implementation, the transmittance of the glass body 10 is 50%-80%. Here, the glass body 10 has a relatively high transmittance, a better permeability, and is more expressive in appearance. Specifically, the transmittance of the glass body 10 may be, but is not limited to, 10%, 20%, 30%, 40%, 50%, 60%, 70%, 75%, 80%, etc.

In implementations of the present disclosure, the glass body 10 is a tempered glass. Therefore, the glass body 10 has an excellent mechanical property, and service life of the housing assembly 100 is prolonged. In an implementation, the glass body 10 may have an impact strength of 500MPa-800MPa. Further, the impact strength of the glass body 10 may be 550MPa-700MPa. Specifically, the impact strength of the glass body 10 may be, but is not limited to, 500MPa, 580MPa, 600MPa, 650MPa, 690MPa, 700MPa, 730MPa, 800MPa, etc.

In the present disclosure, since the first surface 101 of the glass body 10 has the multiple pointed protrusions 11, such that the housing assembly 100 has excellent wear resistance, excellent dirt resistance, and excellent corrosion resistance. In an implementation, the first surface 101 is rubbed by a grey rubber with a load of 1kg, a speed of 50 times/min, and a stroke of 40nm, and the number of wear-resistant times is not less than 1,300. Further, the number of wear-resistant times is not less than 1,500. Furthermore, the number of wear-resistant times is not less than 1,800. In another implementation, the first surface 101 is rubbed by the grey rubber and artificial sweat with the load of 1kg, the speed of 50 times/min, and the stroke of 40nm, and the number of wear-resistant times is not less than 200. In yet another implementation, a dry rubbing test is performed by using a denim, and the number of wear-resistant times is not less than 25,000. Further, the number of wear-resistant times is not less than 29,000. Furthermore, the number of wear-resistant times less than 30,000. In yet another implementation, a wet rubbing test is performed by using a denim, and the number of wear-resistant times is not less than 18,000. Further, the number of wear-resistant times is not less than 20,000. Furthermore, the number of wear-resistant times is not less than 21,000. In yet another implementation, the housing assembly 100 is able to pass a vibratory wear-resistant test at 2 hardness (H). In yet another implementation, there is no scratch on the first surface after being rubbed at least 2,500 times by using BONSTAR 0000# steel wool with a load of 1kg, a steel-wool area of 20mm×20mm, a frequency of 60 times/min, a stroke of 30mm-40mm. Further, there is not scratch on the first surface after being rubbed at least 2,700 times.

The housing assembly 100 provided in the present disclosure has the frosting effect, and realizes the anti-fingerprint effect and the anti-glare effect. In the meanwhile, the first surface 101 is able to reflect the light and produce the pearlescent effect, such that the appearance of the housing assembly 100 is greatly improved. In addition, the pearlescent effect of the first surface 101 is a highly consistent and uniform, and the visual effect is good.

A method for preparing a housing assembly is further provided in the present disclosure. The method is used to prepare the housing assembly 100 in any of the above implementations. The method includes the following. A frosting liquid is provided. Frosting treatment is performed on a first surface of a glass-body precursor and the glass-body precursor frosted is washed to obtain a housing assembly. The frosting liquid contains fluorosilicic acid. In the frosting liquid, cations reacting with the fluorosilicic acid are ammonium ions. The first surface has multiple micrometer-sized pointed protrusions. Each of the multiple pointed protrusions includes an apex, a base, and three lateral surfaces each extending from the apex to the base. In the multiple pointed protrusions, at least 95% of the multiple pointed protrusions each have a length-width ratio of 1:(0.6-3$^{1/2}$/2).

In the present disclosure, a fluorosilicic-acid-salt crystal is formed by a reaction of the frosting liquid and the glass-body precursor, and the fluorosilicic-acid-salt crystal is attached to the first surface 101 of the glass-body precursor. The reaction of the frosting liquid and the glass-body precursor will not occur at the position to which the crystal is attached, and the reaction of the frosting liquid and the glass-body precursor will continue to occur in the region to which the crystal is not attached. After performing the frosting treatment, the glass-body precursor becomes a glass body 10, and a first surface 101 of the glass body 10 to which the fluorosilicic-acid-salt crystal is attached is washed, so as to obtain pointed protrusions 11 formed on the first surface 101 of the glass body 10, thereby producing the housing assembly 100. A morphology of the pointed protrusion 11 is related to a morphology of the crystal formed. In the present disclosure, the cations in the frosting liquid are the ammonium ions, such that most of fluorosilicic acid salt is ammonium fluosilicate, and ammonium fluosilicate is in a polygonal pyramid shape, thereby forming the above pointed protrusions 11. It can be understood that there may be a magnesium-containing compound, a potassium-containing compound, etc., in glass, and the fluorosilicic acid and these substances may also form fluorosilicic acid salt. Compared with ammonium fluosilicate, a content of this fluorosilicic acid salt is very small, which will not affect or change a morphology of an ammonium fluosilicate crystal and a morphology of the pointed protrusion 11 finally formed. The method for preparing the housing assembly 10 is simple, a process flow is few, raw materials come from a wide range of sources, and preparation costs are low. The housing assembly 10 prepared not only has the frosting effect, the anti-fingerprint effect, the anti-glare effect, the anti-slip effect, etc., but also has the sparkling pearlescent effect and is expressive in appearance.

In implementations of the present disclosure, the method can further include the following. Before performing the frosting treatment, the glass-body precursor is washed. Specifically, the glass-body precursor may, but is not limited to, be washed with water and pickled to remove dirt from a surface of the glass-body precursor. In an implementation, the glass-body precursor can be washed with water for 20s-30s, and then the glass-body precursor can be pickled with hydrofluoric acid having a mass concentration of 5% for 15s-20s, such that oil contamination and dirt that are difficult to remove on the surface of the glass-body precursor are removed, thereby realizing a uniform washing and activation effect as the whole.

In implementations of the present disclosure, the method can further include the following. Before performing the frosting treatment, a protective layer is disposed on a surface of the glass-body precursor not subject to the frosting treatment. Therefore, the surface of the glass-body precursor not subject to the frosting treatment is protected, to prevent the surface the glass-body precursor not subject to the frosting treatment from contacting with the frosting liquid. In an implementation, the protective layer is formed by disposing an acid-resistant ink on one side surface of the glass-body precursor. Further, the method further includes the following. After performing the frosting treatment, the protective layer is removed.

In implementations of the present disclosure, before preforming the frosting treatment, the frosting liquid is cured for 24h-36h. By curing, components of the frosting liquid are uniformly mixed, and hydrofluoric acid is slowly produced in the frosting liquid in the process of curing, which is beneficial to performing the frosting treatment. In the meanwhile, compared with directly adding hydrofluoric acid, a reaction in the frosting treatment is more moderate and safer by indirectly producing hydrofluoric acid. Further, a curing temperature is 20°C-50°C. Furthermore, the curing temperature is 25°C-40°C and curing time is 28h-35h.

In implementations of the present disclosure, the method can further include the following. Before performing the frosting treatment, the glass-body precursor and the frosting liquid each are cooled. Therefore, a speed of a subsequent reaction can be slowed down, and a uniformity of crystal distribution and a uniformity and a consistency of pointed protrusions 11 formed can be improved. In an implementation, the glass-body precursor may be treated with, for example, water of 4°C-10°C to cool down, which is not limited herein.

In implementations of the present disclosure, based on parts by weight, the frosting liquid includes 60-100 parts of fluoroammonium salt, 2.5-10 parts of fluorosilicic acid, 35-50 parts of inorganic acid, and 30-50 parts of water. Fluoroammonium salt reacts with inorganic acid to form hydrofluoric acid in the frosting liquid, hydrofluoric acid reacts with silicon dioxide in glass to form fluorosilicic acid ($4HF + SiO_2 \rightarrow SiF_4 + 2H_2O$), and fluorosilicic acid reacts with ammonium ions in fluoroammonium salt to form ammonium fluorosilicate ($H_2SiF_6 + 2NH_4^+ \rightarrow (NH_4)_2SiF_6 + 2H^+$). In the above frosting liquid, inorganic acid is used to provide hydrogen ions, and fluoroammonium salt is used to provide fluorine ions and ammonium ions, which facilitates production of hydrofluoric acid and ammonium fluorosilicate, thereby making the housing assembly 100 have the frosting effect and the pearlescent effect. Fluorosilicic acid is used to form fluorosilicic acid salt, and make a concentration of fluorosilicic acid salt initially formed reach a saturation state, such that fluorosilicic acid salt is precipitated by crystallization and attached to a glass surface. Further, based on parts by weight, the frosting liquid includes 70-95 parts of fluoroammonium salt, 3-9 parts of fluorosilicic acid, 38-50 parts of inorganic acid, and 38-50 parts of water. In an implementation, based on parts by weight, fluoroammonium salt in the frosting liquid accounts for 70-95 parts, 75-90 parts, or 80-90 parts. Specifically, fluoroammonium salt in the frosting liquid accounts for 60 parts, 65 parts, 75 parts, 80 parts, 85 parts, 90 parts, etc. In another implementation, based on parts by weight, fluorosilicic acid in the frosting liquid accounts for 3-9 parts, 4-9 parts, or 5-8 parts. Specifically, fluoroammonium salt in the frosting liquid accounts for 3 parts, 3.5 parts, 4.5 parts, 5.5 parts, 6 parts, 7 parts, etc. In yet another implementation, based on parts by weight, inorganic acid in the frosting liquid accounts for 38-50 parts, 40-48 parts, or 42-47 parts. Specifically, fluoroammonium salt in the frosting liquid accounts for 39 parts, 40 parts, 42 parts, 45 parts, 48 parts, 49 parts, etc. In yet another implementation, based on parts by weight, water in the frosting liquid accounts for 38-50 parts, 40-48 parts, or 43-47 parts. Specifically, water in the frosting liquid accounts for 39 parts, 40 parts, 41 parts, 44 parts, 45 parts, 49 parts, etc.

In implementations of the present disclosure, fluoroammonium salt includes at least one of ammonium hydrogen fluoride ($NH_4HF_2$) or ammonium fluoride ($NH_4F$), and $NH_4HF_2$ and $NH_4F$ each are able to provide fluoride ions and ammonium ions. Further, a mole ratio of $NH_4HF_2$ to $NH_4F$ is 1:(0.8-1.2). In implementations of the present disclosure, inorganic acid may be, but is not limited to, nitric acid, hydrochloric acid, sulfuric acid, etc. In an implementation of the present disclosure, based on parts by weight, the frosting liquid includes 30-50 parts of ammonium hydrogen fluoride $NH_4HF_2$, 30-50 parts of $NH_4F$, 2.5-10 parts of fluorosilicic acid, 35-50 parts of inorganic acid, and 30-50 parts of water. Further, based on parts by weight, the frosting liquid includes 30-40 parts of $NH_4HF_2$, 40-50 parts of $NH_4F$, 3-7 parts of fluorosilicic acid, 40-50 parts of inorganic acid, and 38-45 parts of water. Furthermore, based on parts by weight, the frosting liquid includes 32-48 parts of $NH_4HF_2$, 41-48 parts of $NH_4F$, 3.5-6 parts of fluorosilicic acid, 40-47 parts of inorganic acid, and 40-44 parts of water.

In implementations of the present disclosure, the frosting treatment is performed at 5°C-40°C and for 1min-10min. Under the above condition of frosting treatment, fluorosilicic acid salt can be well attached to the surface of the glass-body precursor, which is beneficial to formation of the pointed protrusion 11. The frosting treatment takes too long time, and fluorosilicic acid salt produced has completely covered the surface of the glass-body precursor, so reaction time does not need to be prolonged and increase of preparation costs are avoided. During actual preparation, time of the frosting treatment can be controlled according to time when fluorosilicic acid salt completely covers the surface of the glass-body precursor. Further, the frosting treatment is performed at 15 °C-35 °C for 2min-8min. Furthermore, the frosting treatment is performed at 20°C-32°C for 3min-7min. In an implementation, the glass can be immersed in the frosting liquid for the frosting treatment. Specifically, the temperature of the frosting treatment may be, but is not limited to, 5°C, 10°C, 15°C, 20°C, 27°C, 30°C, 34°C, 40°C, etc., and the time of the frosting treatment may be, but is not limited to, 1min, 2min, 3min, 4min, 5min, 6min, 7min, 8min, 9min, or 10min.

In the present disclosure, after performing the frosting treatment, the glass-body precursor becomes the glass body 10, and fluorosilicic acid salt is attached to the first surface 101 of the glass body 10. The glass body 10 is separated from the frosting liquid, and the first surface 101 subject to the frosting treatment is washed to remove a fluorosilicic-acid-salt crystal, thereby obtaining the housing assembly 100. Specifically, the first surface 101 can be washed with, for example, water, which is not limited herein. In an implementation, a temperature of washing with water is 20°C-40°C. Specifically, the temperature of the washing with water may be, but is not limited to, 25°C, 30°C, 35°C, 38°C, or 40°C.

In implementations of the present disclosure, the method can further include the following. The housing assembly 100 is reinforced. In other words, the glass body 10 is reinforced. In an implementation, the glass body 10 is reinforced by chemical reinforcement. Specifically, the glass body 10 can be subject to, for example, a salt bath, which is not limited herein. The salt bath is performed with at least one of sodium salt and potassium salt at 400°C-500°C for 2h-10h.

In implementations of the present disclosure, the method can further include the following. Computer numerical control (CNC) machining is performed on the housing assembly 100 to obtain a housing assembly 100 that satisfies application needs.

The preparing method provided in the present disclosure is simple and convenient to operate, and the housing assembly 100 with both the frosting effect and the pearlescent effect can be obtained, such that the appearance effect of the housing assembly 100 is greatly improved and enhanced, which is beneficial to the application of the housing assembly 100.

An electronic device is further provided in the present disclosure. The electronic device includes the housing assembly 100 of any of the above implementations. It can be understood that the electronic device may be, but is not limited to, a mobile phones, a tablet computer, a laptop, a watch, a moving picture experts group audio layer 3 (MP3), a moving picture experts group audio layer 4 (MP4), a global positioning system (GPS) navigator, a digital camera, etc. A mobile phone is taken as an example for description below. Reference is made to FIG. 6, which is a schematic structural view of an electronic device provided in an implementation of the present disclosure. The electronic device includes a housing assembly 100 and a main board. The electronic device having the above housing assembly 100 can not only have the frosting effect to realize anti-fingerprint, anti-glare, and anti-slip, but also have the pearlescent effect, which greatly improves an appearance of the electronic device and satisfy the needs of users.

Implementation 1

A method for preparing a housing assembly includes the following. 30 parts of $NH_4HF_2$, 40 parts of $NH_4F$, 5 parts of fluorosilicic acid, 50 parts of nitric acid, and 50 parts of water are mixed and stirred uniformly, and cured for 24h. After disposing an ink protective layer on a first surface of glass, the glass is placed in the above frosting liquid for frosting treatment at 30°C for 4min. The glass subject to the frosting treatment is taken out and washed with water, and the ink protective layer is removed to obtain the housing assembly.

Comparative example 1

A method for preparing a housing assembly includes the following. 30 parts of potassium fluoride, 20 parts of sulfuric acid, 10 parts of kaolin, and 40 parts of water are mixed and stirred uniformly, and cured for 24h. The remaining operations are consistent with the conditions of implementation 1.

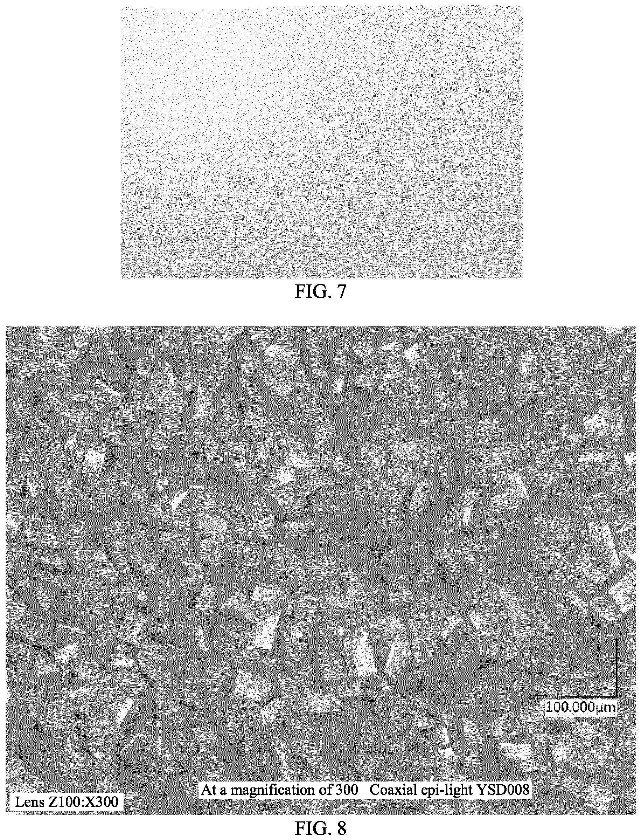

By visually observing the housing assembly prepared in implementation 1 and the housing assembly prepared in comparative example 1, it can be obviously seen that the housing assembly prepared in implementation 1 not only has a frosting effect, but also has a pearlescent effect. When rotating the housing assembly, a delicate and shining effect appears. However, the glass prepared in comparative example 1 only has a frosting effect without a pearlescent effect. The housing assembly prepared in implementation 1 is photographed, and results are illustrated in FIG. 7. It can be seen that the housing assembly prepared in implementation 1 has an obvious pearlescent effect and a good sparkling intensity.

A property of the housing assembly prepared in implementation 1 and a property of the housing assembly prepared in comparative example 1 are tested by a light transmittance meter (at a wavelength of 550nm), a haze meter, and a roughness meter. The housing assembly prepared in implementation 1 has a transmittance of 50% and a haze of 80%, and a first surface of the housing assembly prepared in implementation 1 has a surface roughness of $1\mu m$. The housing assembly prepared in comparative example 1 has a transmittance of 60% and a haze of 50%, and a frosting surface of the housing assembly prepared in comparative example 1 has a surface roughness of $0.3\mu m$.

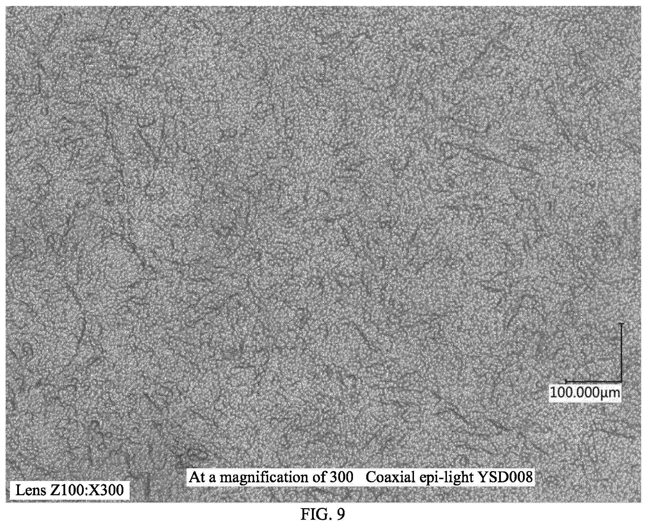

Surface microstructures of the housing assembly prepared in implementation 1 and surface microstructures of the housing assembly prepared in comparative example 1 are tested by using an optical microscope of KEYENCE CORPORATION, and results are illustrated in FIG. 8 and FIG. 9, where FIG. 8 is a schematic view of surface microstructures of a housing assembly prepared in implementation 1, and FIG. 9 a schematic view of surface microstructures of a housing assembly prepared in comparative example 1. It can be seen that the housing assembly prepared in implementation 1 has multiple pointed protrusions on the surface of the housing assembly. However, the housing assembly prepared in comparative example 1 has multiple spherical particles on the surface of the housing assembly. A micro-morphology of the pointed protrusion is quite different from a micro-morphology of the spherical particle. In addition, it can be seen from the figure that a size of the pointed protrusion is also quite different from a size of the spherical particle.

Tests illustrated in table 1 are performed on the housing assembly prepared in implementation 1 and the housing assembly prepared in comparative example 1, and test results are illustrated in table 2. It can be seen that the housing assembly prepared in implementation 1 has far better dirt resistance and wear resistance than the housing assembly prepared in comparative example 1, and has a great application prospect.

Table 1 Test items

| Name | The number of tests | Test method |
| --- | --- | --- |
| Dirt-resistant test 1 | 5 | Draw a straight line of 3cm on a test plate with a ZEBAR oil pen and place the test plate drawn at room temperature for 5min. Wet a dust-free cloth with water and then wash the test plate drawn. Wipe the line 200 times with a force of not less than 3kg diagonally. If a stain is unable to be washed by water, wet the dust-free cloth with ethanol and then wash the stain again. Wipe the line 200 times with a force of not less than 3kg. |

(continued)

| Name | The number of tests | Test method |
|---|---|---|
| Dirt-resistant test 2 | 5 | Draw three straight lines of 5cm on a test plate with a ZEBAR oil pen with proper force, and place the test plate drawn in an environment of 55±2°C and 93±2% relative humidity (RH) for 2h. Take out the test plate drawn and place the test plate drawn at room temperature for 1h. Wet a dust-free cloth with ethanol, and then wipe the test plate drawn for 20 times with a force of not less than 3kg diagonally. |
| Rub with a desktop | 5 | Assemble into a device model (e.g., counterweight iron, where the weight of the counterweight iron refers to the weight of the whole device) to test for 10,000 times, and check once every 1,000 times. |
| Rub with a grey rubber | 5 | Rub with a load of lkg, a speed of 50 times/min, a stroke of 40nm, check once every 100 times until obvious appearance defects appear, and record the limit number. |
| Rub with gray rubber and artificial sweat | 5 | Rub with a load of lkg, a speed of 50 times/min, a stroke of 40nm, check once every 100 times until obvious appearance defects appear, and record the limit number. |
| Rub with a denim | 5 | For a test on a sample bearing weight, dry rub 2 pieces (pcs) of samples each for 200,000 times, and check once every 1000 times. Wet rub 2pcs of samples each for 200,000 times, and check once every 2,000 times. |
| Vibratory wear-resistant test | 5 | Assemble into a device model (e.g., counterweight iron, where the weight of the counterweight iron refers to the weight of the whole device) to test for vibratory wear resistant at 0.5H/1H/2H/4H/8H |
| Rub with steel wool | 5 | Use BONSTAR 0000# steel wool with a steel-wool area of 20mm×20mm (e.g., a moving direction is in a direction of steel-wool fiber), a load of lkg, a test frequency of 60 times/min (e.g., one time is a reciprocating motion), and a stroke of 30mm-40mm (e.g., the steel wool is not separated from the sample), and check once every 100 times. |

Table 2 Test results

| Name | Implementation 1 | Comparative example 1 |
|---|---|---|
| Dirt-resistant test 1 | There is no residue of the straight line drawn bv the oil pen after being washed with water. | There is a residue of the straight line drawn by the oil pen |
| Dirt-resistant test 2 | There is no residue of the straight line drawn bv the oil pen. | There is a residue of the straight line drawn by the oil pen |
| Rub with a desktop | There is no scratch on the surface after being rubbed 2,000 times. | There is no scratch on the surface after being rubbed 1,000 times. |
| Rub with a grey rubber | There is no scratch on the surface after being rubbed 1,500 times. | There is no scratch on the surface after being rubbed 500 times. |
| Rub with gray rubber and artificial sweat | There is no scratch on the surface after being rubbed 200 times. | There is no scratch on the surface after being rubbed 100 times. |
| Rub with a denim | There is no scratch on the surface after being dry rubbed 29,000 times. There is no scratch on the surface after being wet rubbed 20,000 times | There is no scratch on the surface after being dry rubbed 10,000 times. There is no scratch on the surface after being wet rubbed 10,000 times |
| Vibratory wear-resistant test | There is no scratch on the surface at 2H | There is no scratch on the surface at 2H |

(continued)

| Name | Implementation 1 | Comparative example 1 |
|------|------------------|------------------------|
| Rub with steel wool | There is no scratch on the surface after being rubbed 2,500 times. | A frosting effect of the surface does not change after being rubbed 200 times, but the surface is dirty. |

Content provided by implementations of the present disclosure has been introduced in detail in the above, and principles and implementations of the present disclosure are illustrated and explained herein. Above explanations are only for facilitating understanding of the methods and core ideas of the present disclosure. At the same time, according to the ideas of the present disclosure, changes in specific implementations and an application scope can be made by those ordinary skilled in this art. To sum up, Content of this specification should not be construed as limitation of the present disclosure.

## Claims

1. A housing assembly, comprising a glass body, wherein the glass body has a first surface, the first surface has a plurality of micrometer-sized pointed protrusions, each of the plurality of pointed protrusions comprises an apex, a base, and three lateral surfaces each extending from the apex to the base, wherein in the plurality of pointed protrusions, at least 95% of the plurality of pointed protrusions each have a length-width ratio of $1:(0.6\text{-}3^{1/2}/2)$.

2. The housing assembly of claim 1, wherein the plurality of pointed protrusions have at least one of a triangular pyramid structure or a triangular pyramid-like structure.

3. The housing assembly of claim 1, wherein in the plurality of pointed protrusions, at least 95% of the plurality of pointed protrusions each have the length-width ratio of $1:(0.7\text{-}3^{1/2}/2)$.

4. The housing assembly of claim 1, wherein each of the plurality of pointed protrusions has a height ranging from $0.5\mu m$ to $3\mu m$.

5. The housing assembly of claim 1, wherein each of the plurality of pointed protrusions has a length ranging from $20\mu m$ to $200\mu m$.

6. The housing assembly of claim 1, wherein an interval between adjacent pointed protrusions ranges from $0\mu m$ to $30\mu m$.

7. The housing assembly of claim 1, wherein each of the plurality of pointed protrusions has a length-height ratio greater than 7.

8. The housing assembly of claim 1, wherein the three lateral surfaces have an area ratio of $1:(0.9\text{-}1):(0.9:1)$.

9. The housing assembly of claim 1, wherein each of the plurality of pointed protrusions has a first edge, a second edge, and a third edge, and a ratio of the first edge to the second edge to the third edge is $1:(0.8\text{-}1):(0.8:1)$.

10. The housing assembly of claim 1, wherein the plurality of pointed protrusions each have a first edge, a second edge, and a third edge, and a ratio of the first edge to a height of the pointed protrusion is $1:(0.01\text{-}15)$.

11. The housing assembly of claim 1, wherein the first surface has a surface roughness ranging from $0.5\mu m$ to $3\mu m$, and the glass body has a haze ranging from 30% to 90% and a transmittance ranging from 10% to 80%.

12. The housing assembly of claim 1, wherein the glass body is tempered glass.

13. The housing assembly of claim 1, further comprising a protective layer disposed on the first surface of the glass housing, wherein the protective layer has a thickness less than $50\mu m$.

14. A method for preparing a housing assembly, comprising:

EP 4 250 882 A1

providing a frosting liquid, and performing frosting treatment on a first surface of a glass-body precursor and washing the glass-body precursor frosted to obtain the housing assembly, wherein the frosting liquid contains fluorosilicic acid, and in the frosting liquid, cations reacting with the fluorosilicic acid are ammonium ions; and the first surface has a plurality of micrometer-sized pointed protrusions, and each of the plurality of pointed protrusions comprises an apex, a base, and three lateral surfaces each extending from the apex to the base, wherein in the plurality of pointed protrusions, at least 95% of the plurality of pointed protrusions each have a length-width ratio of $1:(0.6\text{-}3^{1/2}/2)$.

15. The method of claim 14, wherein based on parts by weight, the frosting liquid comprises 60-100 parts of fluoroammonium salt, 2.5-10 parts of fluorosilicic acid, 35-50 parts of inorganic acid, and 30-50 parts of water.

16. The method of claim 15, wherein based on parts by weight, the frosting liquid comprises 30-50 parts of ammonium hydrogen fluoride ($NH_4HF_2$), 30-50 parts of ammonium fluoride ($NH_4F$), 2.5-10 parts of fluorosilicic acid, 35-50 parts of inorganic acid, and 30-50 parts of water.

17. The method of claim 14, wherein the frosting treatment is performed at 5°C-40°C for 1min-10min.

18. The method of claim 14, wherein before preforming the frosting treatment, the frosting liquid is cured for 24h-36h.

19. The method of claim 14, further comprising reinforcing the housing assembly.

20. An electronic device, comprising a housing assembly and a main board, wherein the housing assembly comprises a glass body, the glass body has a first surface, the first surface has a plurality of micrometer-sized pointed protrusions, and each of the plurality of pointed protrusions comprises an apex, a base, and three lateral surfaces each extending from the apex to the base, wherein in the plurality of pointed protrusions, at least 95% of the plurality of pointed protrusions each have a length-width ratio of $1:(0.6\text{-}3^{1/2}/2)$.

100

11

A

101

10

102

FIG. 1

FIG. 2

FIG. 3

FIG. 4

FIG. 5

FIG. 6

FIG. 7

Lens Z100:X300

At a magnification of 300   Coaxial epi-light YSD008

100.000μm

FIG. 8

Lens Z100:X300

At a magnification of 300   Coaxial epi-light YSD008

100.000μm

FIG. 9

## INTERNATIONAL SEARCH REPORT

| International application No. |
|---|
| **PCT/CN2021/122256** |

**A. CLASSIFICATION OF SUBJECT MATTER**

H05K 5/02(2006.01)i; C03C 15/00(2006.01)i; H04M 1/02(2006.01)i

According to International Patent Classification (IPC) or to both national classification and IPC

**B. FIELDS SEARCHED**

Minimum documentation searched (classification system followed by classification symbols)

H05K; C03C; H04M

Documentation searched other than minimum documentation to the extent that such documents are included in the fields searched

Electronic data base consulted during the international search (name of data base and, where practicable, search terms used)

CNABS; CNTXT; VEN; WOTXT; USTXT; EPTXT; CNKI; IEEE: 凸起, 突起, 尖, 棱, 锥, 玻璃, 蒙砂, 壳, 盖, protru+, pyramid, glass, cover, housing, casing, frost+

**C. DOCUMENTS CONSIDERED TO BE RELEVANT**

| Category* | Citation of document, with indication, where appropriate, of the relevant passages | Relevant to claim No. |
|---|---|---|
| PX | CN 112616274 A (VIVO COMMUNICATION TECHNOLOGY CO., LTD.) 06 April 2021 (2021-04-06) description, paragraphs [0006]-[0055], and figures 1 and 2 | 1-13, 20 |
| X | CN 110467354 A (GUANGDONG OPPO MOBILE TELECOMMUNICATIONS CORP., LTD.) 19 November 2019 (2019-11-19) description, paragraphs [0016]-[0072], and figures 1-5 | 1-20 |
| X | CN 110996580 A (VIVO COMMUNICATION TECHNOLOGY CO., LTD.) 10 April 2020 (2020-04-10) description, paragraphs [0029]-[0055], and figures 1-5 | 1-13, 20 |
| A | CN 103068192 A (SHENZHEN FUTAIHONG PRECISION INDUSTRY CO., LTD.) 24 April 2013 (2013-04-24) entire document | 1-20 |

☐ Further documents are listed in the continuation of Box C. ☑ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **19 November 2021** | **20 December 2021** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/122256**

| Patent document cited in search report | | | Publication date (day/month/year) | Patent family member(s) | | | Publication date (day/month/year) |
|---|---|---|---|---|---|---|---|
| CN | 112616274 | A | 06 April 2021 | None | | | |
| CN | 110467354 | A | 19 November 2019 | None | | | |
| CN | 110996580 | A | 10 April 2020 | None | | | |
| CN | 103068192 | A | 24 April 2013 | US | 2013100592 | A1 | 25 April 2013 |
| | | | | EP | 2587903 | A3 | 01 July 2015 |
| | | | | EP | 2587903 | A2 | 01 May 2013 |

Form PCT/ISA/210 (patent family annex) (January 2015)